Europäisches Patentamt

European Patent Office

Office européen des brevets

(11) Veröffentlichungsnummer: **0 613 250 A1**

# EUROPÄISCHE PATENTANMELDUNG

(21) Anmeldenummer: **94100346.9**

(22) Anmeldetag: **12.01.94**

(51) Int. Cl.5: **H03K 21/10**, H03K 23/66, H03K 23/68, H03L 7/197

(30) Priorität: **29.01.93 DE 4302439**

(43) Veröffentlichungstag der Anmeldung: **31.08.94 Patentblatt 94/35**

(84) Benannte Vertragsstaaten: **AT CH DE ES FR GB IT LI PT**

(71) Anmelder: **Blaupunkt-Werke GmbH Robert-Bosch-Strasse 200 D-31139 Hildesheim (DE)**

(72) Erfinder: **Bartels, Stefan, Dr. Kirchplatz 6 D-29553 Bienenbüttel (DE)** Erfinder: **Schwarz, Detlef Kötnerholzweg 38 D-30451 Hannover (DE)**

(74) Vertreter: **Eilers, Norbert, Dipl.-Phys. Blaupunkt-Werke GmbH Patente und Lizenzen Postfach 77 77 77 D-31132 Hildesheim (DE)**

(54) Schaltungsanordnung zur Phasenkorrektur in Ausgangssignalen eines Frequenzteilers.

(57) Bei einer Schaltungsanordnung zur Phasenkorrektur in Ausgangssignalen eines Frequenzteilers (4), der die Frequenz eines zugeführten Oszillator-Signals (51) in einem nicht-ganzzahligen, insbesondere halbzahligen, Teilerverhältnis teilt, wird jeder zweite Impuls im Ausgangssignal (52) des Frequenzteilers (4) um eine halbe Periode des Oszillator-Signals (51) verzögert.

Fig.1

EP 0 613 250 A1

Die Erfindung geht aus von einer Schaltungsanordnung nach der Gattung des Hauptanspruchs.

Bei Frequenzteilern mit nicht-ganzzahligen Teilerverhältnissen entspricht zwar die mittlere Frequenz der Ausgangssignale dem gewünschten Wert, die Ausgangsimpulse sind jedoch nicht äquidistant. Bei dem Einsatz derartiger Teiler in PLL-Schaltungen werden in einem Phasendetektor diese Impulse mit den Impulsen eines Referenzsignals verglichen. Letztere sind jedoch äquidistant, was dazu führt, daß der Phasendetektor trotz Frequenzgleichheit der zu vergleichenden Signale ein Fehlersignal erzeugt, das zu dem bekannten erhöhten Phasenrauschen von PLL-Oszillatoren mit nicht-ganzzahligem Teilerverhältnis führt.

Zur Vermeidung dieses Nachteils sind bereits Maßnahmen zur Korrektur des jeweiligen Phasenfehlers nach dem Phasendetektor durch das Buch von Best, R. "PHASE-LOCKED LOOPS", McGraw Hill Book Co. 1984, Seiten 222, 223 und 229 bekanntgeworden. Diese Maßnahmen sind jedoch sehr aufwendig.

Der Erfindung liegt daher die Aufgabe zugrunde, die Impulse eines Ausgangssignals eines Frequenzteilers mit einem nicht-ganzzahligen Teilerverhältnis, insbesondere mit einem halbzahligen Teilerverhältnis $L = (2N+1)/2$, äquidistant zu machen, um das erhöhte Phasenrauschen in PLL-Schaltungen zu vermeiden.

Die erfindungsgemäße Schaltungsanordnung mit den kennzeichnenden Merkmalen des Hauptanspruchs erzeugt ein korrigiertes Ausgangssignal mit äquidistanten Impulsen. Ein weiterer Vorteil dieser Schaltungsanordnung besteht darin, daß sie mit wenigen in der digitalen Schaltungstechnik üblichen Baugruppen realisiert werden kann.

Durch die in den Unteransprüchen aufgeführten Maßnahmen sind vorteilhafte Weiterbildungen und Verbesserungen der im Hauptanspruch angegebenen Erfindung möglich.

Ein Ausführungsbeispiel der Erfindung ist in der Zeichnung anhand mehrerer Figuren im Zusammenhang mit einer PLL-Schaltung dargestellt und in der nachfolgenden Beschreibung näher erläutert. Es zeigt:

Fig. 1      ein Blockschaltbild einer erfindungsgemäßen Schaltungsanordnung,

Fig. 2      ein Blockschaltbild einer bekannten PLL-Schaltung,

Fig. 3      ein Beispiel für eine Ausführung der erfindungsgemäßen Schaltungsanordnung nach Fig. 1 und

Fig. 4      Zeitdiagramme von bei den Schaltungsanordnungen nach den Figuren 1 bis 3 auftretenden Signalen.

Gleiche Teile sind in den Figuren mit gleichen Bezugszeichen versehen.

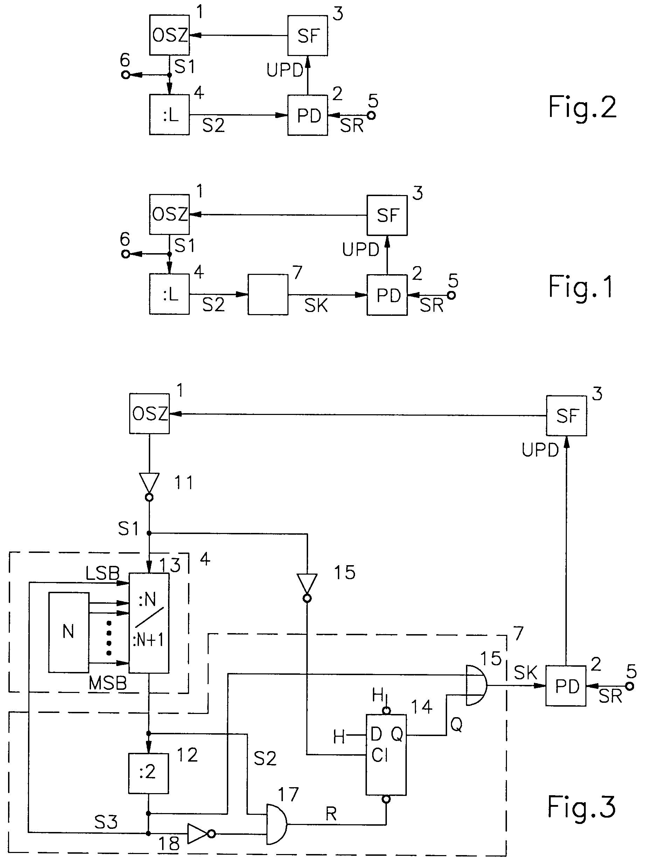

Eine bekannte häufig verwendete PLL-Schaltung zur Abstimmung eines Rundfunkempfängers ist in Fig. 2 als Blockschaltbild dargestellt. Sie erhält einen steuerbaren Oszillator 1, dem von einem Phasendetektor 2 über ein Schleifenfilter 3 eine Abstimmspannung zuführbar ist. Das Ausgangssignal S1 des steuerbaren Oszillators 1 ist einem Ausgang 6 entnehmbar und wird einem Frequenzteiler 4 zugeführt, dessen Ausgangssignal S2 in einem nicht-ganzzahligen Teilerverhältnis zum Signal S1 steht.

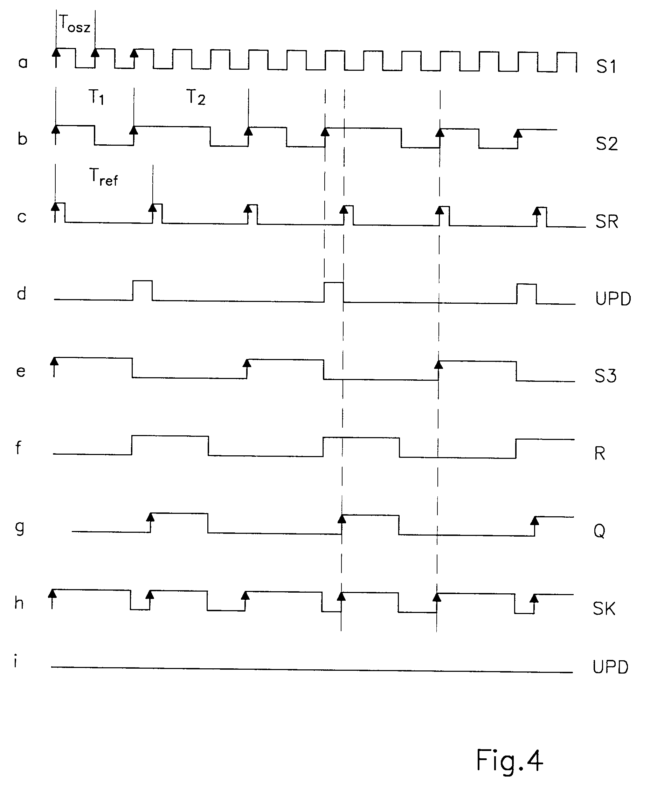

Das Signal S2 wird im Phasendetektor 2 mit einem bei 5 zugeführten Referenzsignal verglichen, wodurch die Abstimmspannung erzeugt wird. Bei nicht-äquidistanten Impulsen kommt es zu einer Erhöhung des Phasenrauschens, wie im folgenden anhand von Fig. 4 erläutert wird.

Zeile a der Fig. 4 zeigt das Oszillator-Signal S1 mit der Periodendauer $T_{osz}$. Daraus wird in dem Frequenzteiler 4 das in Zeile b dargestellte Signal abgeleitet, dessen mittlere Frequenz einem halbzahligen Teil der Frequenz des Oszillator-Signals S1 entspricht - im dargestellten Fall dem Teilerverhältnis 2,5. Es wechseln sich jeweils zwei Periodendauern $T1 = 2T_{osz}$ und $T2 = 3T_{osz}$ ab.

Das Signal S2 wird bei der Schaltungsanordnung nach Fig. 1 mit Hilfe des Phasendetektors 2 mit einem Referenzsignal SR verglichen. Die Frequenz des Signals SR, das in Zeile c dargestellt ist, beträgt $f_{ref} = f_{osz}/2,5$. Die Periodendauer des Signals SR ist gleichbleibend $T_{ref} = 2,5 \cdot T_{osz}$. Durch den Phasenvergleich entsteht dann die in Zeile d dargestellte Ausgangsspannung UPD des Phasendetektors 2. Obwohl die Frequenz und Phasenlage des Signals S2 bezüglich des Signals SR stimmen, treten in jeder zweiten Periode Impulse auf, welche zu der oben erwähnten Erhöhung des Phasenrauschens führen.

Fig. 1 zeigt eine PLL-Schaltung mit einer erfindungsgemäßen Schaltungsanordnung 7, welche in den Signalweg zwischen dem Frequenzteiler 4 und dem Phasendetektor 2 eingefügt ist. Außerdem erhält die erfindungsgemäße Schaltungsanordnung 7 das Signal S1 vom steuerbaren Oszillator 1. Die Schaltungsanordnung 7 liefert das in Zeile h (Fig. 4) dargestellte korrigierte Signal SK an den Phasendetektor 2. Wie aus Fig. 4 ersichtlich ist, haben die durch einen Pfeil hervorgehobenen positiven Flanken des Signals SK gleiche Abstände, nämlich jeweils die Periodendauer $T_{ref}$.

Fig. 3 zeigt innerhalb einer PLL-Schaltung ein Ausführungsbeispiel für die Schaltungsanordnung 7 (Fig. 1). Außerdem ist der Frequenzteiler 4 gegenüber Fig. 1 etwas detaillierterer dargestellt. Dem Frequenzteiler 4 wird das Signal S1 über einen Invertierer 11 zugeführt. Der Frequenzteiler ist zur Sendereinstellung programmierbar ausgeführt, wobei zur Realisierung von halbzahligen Teilerverhältnissen L ein Zweiteiler 12 dem Frequenzteiler 4 nachgeschaltet ist, dessen Ausgangssignal S3 der geringstwertigen Binärstelle LSB von Load-Eingängen eines programmierbaren Zählers 13 zuführbar ist. Die anderen Binärstellen werden von einer Zahl N gebildet, welche zur Einstellung des jeweiligen Senders eingegeben wird. Das Ausgangssignal S2 des Frequenzteilers 4 entsteht somit durch abwechselnde Frequenzteilung durch N und N + 1.

Um für den Phasendetektor 2 äquidistante Impulse zu erhalten, werden das Signal S3 und das Ausgangssignal Q eines Flip-Flops 14 über eine Oder-Schaltung 15 geleitet.

Das Flip-Flop wird von einem bei 16 invertierten Oszillator-Signal S1 getaktet und von einem invertierten Ausgangssignal einer Und-Schaltung 17 zurückgesetzt. Der Und-Schaltung 17 sind das Signal S2 und das bei 18 invertierte Signal S3 zuführbar.

Zeile e (Fig. 4) zeigt das Signal S3, wobei die positiven Flanken durch Pfeile hervorgehoben sind. Zeile f stellt das Signal R dar, dessen negative Flanken das Flip-Flop 14 zurücksetzen. Da sowohl der Dateneingang D als auch ein invertierender Setzeingang des Flip-Flops 14 mit H-Pegel beaufschlagt sind, wird das Flip-Flop 14 durch die jeweils auf ein Rücksetzen folgende negative Flanke des Oszillator-Signals S1 gesetzt. Daraus ergibt sich die in Zeile g dargestellte Signalform, deren positive Flanken mit jeweils einer fallenden Flanke des Signals S1 koinzidieren und die jeweils zweite steigende Flanke des Signals SK (Zeile h) bilden. Zeile i stellt dann die Ausgangsspannung UPD des Phasendetektors 2 im Falle des korrigierten Signals SK dar.

**Patentansprüche**

1.  Schaltungsanordnung zur Phasenkorrektur in Ausgangssignalen eines Frequenzteilers, der die Frequenz eines zugeführten Oszillator-Signals in einem nicht-ganzzahligen, insbesondere halbzahligen, Teilerverhältnis teilt, dadurch gekennzeichnet, daß jeder zweite Impuls im Ausgangssignal des Frequenzteilers (4) um eine halbe Periode des Oszillator-Signals verzögert wird.

2.  Schaltungsanordnung nach Anspruch 1, dadurch gekennzeichnet, daß aus dem Ausgangssignal des Frequenzteilers (4) ein Signal mit halber Frequenz abgeleitet wird, daß in Abhängigkeit vom Signal halber Frequenz Flanken des korrigierten Ausgangssignals entweder von positiven oder von negativen Flanken des Oszillator-Signals abgeleitet werden.

3.  Schaltungsanordnung nach Anspruch 2, dadurch gekennzeichnet, daß der Ausgang des Frequenzteilers (4) mit einem Eingang eines Zweiteilers (12) verbunden ist, daß der Eingang und ein Ausgang des Zweiteilers (12) über eine Logikschaltung (17) mit dem Rücksetzeingang eines Flip-Flops (14) verbunden sind, das von dem Oszillator-Signal getaktet wird, und daß ein Ausgang des Flip-Flops (14) und der Ausgang des Zweiteilers (12) an je einen Eingang einer weiteren Logikschaltung (15) angeschlossen sind, deren Ausgang das korrigierte Ausgangssignal führt.

4.  Schaltungsanordnung nach Anspruch 3, dadurch gekennzeichnet, daß die Logikschaltung eine Und-Schaltung (17) und die weitere Logikschaltung eine Oder-Schaltung (15) ist.

5.  Schaltungsanordnung nach Anspruch 3, dadurch gekennzeichnet, daß der Frequenzteiler (4) von einem programmierbaren Zähler (13) gebildet wird, der abwechselnd bis zur unterhalb des Teilerverhältnisses liegenden ganzen Zahl und bis zur oberhalb des Teilerverhältnisses liegenden ganzen Zahl zählt.

Fig.2

Fig.1

Fig.3

Fig.4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| D,A | R. E. BEST: 'Phase-locked loops'<br>1984 , MCGRAW-HILL BOOK CO. , NEW YORK<br>* Seiten 217 - 229, insbesondere Seiten 222, 223 und 229 *<br>--- | 1 | H03K21/10<br>H03K23/66<br>H03K23/68<br>H03L7/197 |
| A | GB-A-2 095 444 (WAVETEK)<br>* das ganze Dokument *<br>--- | 1 | |
| A | GB-A-2 239 115 (PHILIPS ELECTRONICS AND ASSOCIATED INDUSTRIES LIMITED)<br>* das ganze Dokument *<br>--- | 1 | |
| A | DE-C-40 16 951 (ANT NACHRICHTENTECHNIK GMBH)<br>* das ganze Dokument *<br>--- | 1 | |
| A | DE-A-19 58 662 (SIEMENS AG)<br>* das ganze Dokument *<br>--- | 1 | |
| A | US-A-4 573 176 (R. O. YEAGER)<br>* das ganze Dokument *<br>--- | 1 | RECHERCHIERTE SACHGEBIETE (Int.Cl.5) |
| A | EDN-ELECTRICAL DESIGN NEWS,<br>Bd.36, Nr.12, 6. Juni 1991, NEWTON, MA, US<br>Seite 174<br>Y. ZIA: 'Divider splits the divisor'<br>* das ganze Dokument *<br>----- | 1 | H03K<br>H03L |

Der vorliegende Recherchenbericht wurde für alle Patentansprüche erstellt

| Recherchenort | Abschlußdatum der Recherche | Prüfer |
|---|---|---|
| BERLIN | 31. Mai 1994 | Arendt, M |